# EUROPEAN PATENT SPECIFICATION

(11) **EP 3 261 111 B1**
(45) Date of publication and mention of the grant of the patent: **15.02.2023**
(21) Application number: 17386017.2
(22) Date of filing: 26.04.2017
(51) Int. Cl.: H01J 37/32

(54) **VARIABLE FARADAY SHIELD FOR A SUBSTRATE HOLDER, A CLAMPING RING, OR AN ELECTRODE, OR THEIR COMBINATION IN A PLASMA REACTOR, USE OF THE VARIABLE SHIELD AND METHOD FOR CONTROLLING ROUGHNESS**
VARIABLER FARADAY-SCHIRM FÜR EINEN SUBSTRATHALTER, EINEN KLEMMRING ODER EINE ELEKTRODE ODER DEREN KOMBINATION IN EINEM PLASMAREAKTOR, VERWENDUNG DES VARIABLEN FARADAY-SCHIRMS UND VERFAHREN ZUR STEUERUNG DER RAUHEIT
ÉCRAN DE FARADAY VARIABLE POUR UN SUPPORT DE SUBSTRAT, BAGUE DE SERRAGE OU ÉLECTRODE OU LEUR COMBINAISON DANS UN RÉACTEUR À PLASMA, UTILISATION DE L'ÉCRAN DE FARADAY VARIABLE ET PROCÉDÉ DE CONTRÔLE DE LA RUGOSITÉ

(30) Priority: 27.04.2016 GR 20160100220
(43) Date of publication of application: 27.12.2017
(73) Proprietor: NATIONAL CENTER FOR SCIENTIFIC RESEARCH "DEMOKRITOS", 15341 Agia Paraskevi Attikis (GR); Gogolides, Evangelos, 15341 Agia Paraskevi Attikis (GR)
(72) Inventor: GOGOLIDES, Evangelos, 15341 Agia Paraskevi (GR); ZENIOU, Angelos, 15341 Agia Paraskevi (GR)

(56) References cited:
- WO-A1-00/23633
- WO-A1-02/072913
- KR-A- 20040 008 882
- US-A1- 2008 283 500
- US-A1- 2014 123 895
- US-A1- 2014 134 829

## Description

### Field of the invention

The present invention is related generally to the field of electrical shielding and in particular to a Faraday shield for use with a plasma apparatus, such as RIE (Reactive Ion Etching), ICP (Inductively Coupled Plasma), or other. Plasma processing in such apparatus will result in controlled roughness formation on a substrate during plasma processing.

### State of the Art and Background of the Invention

For those working in the field of plasma processing, it is known that Radio Frequency (RF) capacitive coupling is reduced by the use of Faraday shields, also called electrostatic shields, hereafter referred to as shields. Shields are commonly used when ion erosion of plasma reactor surfaces, such as reactor walls and electrodes, needs to be eliminated or reduced. Ion erosion is due to plasma ion acceleration from the electric fields created from the capacitive coupling of surfaces to the plasma. In RIE and ICP systems sputtering from the substrate holder is a common issue. As the plasma breaks down, high-energy ions (with energy ranging from several electron volts to several hundreds of electron volts) are accelerated along the electric field lines toward the substrate. These high-energy ions, are damaging the substrate holder (in the area not covered by the substrate) resulting in sputtering of the clamping ring of the substrate or of the substrate holder material. As a result of sputtering, roughness is created on the surface of the substrate material being etched due to the so called "micro masking" effect. A common effect of sputtering is "grass" formation i.e. highly rough etched surface on the substrate. Indeed, typically the material sputtered from the substrate holder is unetchable, and as it falls on the substrate being etched, it creates tiny local micro-masks, which prevent etching and lead to surface roughness formation [E F. Chen, in High Density Plasma Sources, edited by 0. A. Popov (Noyes, New York, 1995)]. The phenomenon is more pronounced under conditions of low-pressure etching, when etching anisotropy (i.e. preferential etching in the direction perpendicular to the substrate) prevails.

In the literature all efforts are targeted in eliminating sputtering from the substrate holder, the clamping ring of the substrate, or from other reactor walls, in order to achieve smooth etched surfaces. However, there are cases, where etching roughness is beneficial and may result in new functional materials with controlled properties, such as wetting properties, biomolecule binding, cell adhesion, fouling or antifouling, optical and other properties.

[Evangelos Gogolides, Vassilios Constantoudis, George Kokkoris, Dimitrios Kontziampasis, Katerina Tsougeni, George Boulousis, Marilena Vlachopoulou and Angeliki Tserepi Controlling roughness: from etching to nanotexturing and plasmadirected organization on organic and inorganic materials, Journal of Physics D: Applied Physics 44(17) 2011, 174021].

Hence, the ability to control roughness at will, by controlling the amount of sputtering is a matter of great importance for applications and for modern plasma reactor design, and no solutions are available.

Wayne L. Johnson [Wayne L. Johnson, US Patent 5234529 A] designed a plasma generating apparatus with a capacitive shield that is placed in between the RF coil and the plasma region for limiting the amount of capacitive coupling in an ICP reactor. Their shield can include a means for varying the shielding effect by varying the amount of capacitive coupling.

Marwan H. Khater et al. [Marwan Khater, Lawrence Overzet, US Patent 20020023899] patented a properly designed and positioned Faraday shield/dielectric spacer/source-coil assembly that is used to nearly fix the input impedance of an Inductively Coupled Plasma (ICP) source-coil, making a variable matching network almost unnecessary, and allowing for pulsed plasma processing with very little reflected power. An appropriately positioned aperture in the Faraday shield can allow enough capacitive coupling between the vacuum and ICP source coil to ignite the plasma while preventing any significant capacitive coupling during the subsequent high-density ICP phase.

Similar work has been demonstrated by Kato Hitoshi et al., Motokawa Takeharu et al. and Matthew F. Davis et al. They designed variable Faraday shields positioned between the excitation source (antenna) and the plasma chamber for controlling the capacitive coupling and the electromagnetic fields going inside the plasma chamber. [Hitoshi Kato, Shigehiro Miura, US Patent 20140123895A*,* Takeharu Motokawa, US Patent 20080283500A1 and Matthew F. Davis, Frank Hooshdaran, WO 02/072913A1*].*

Pradeep Dixit et al. [Pradeep Dixit and Jianmin Miao, "Effect of Clamping Ring Materials and Chuck Temperature on the Formation of Silicon Nanograss in Deep RIE", Journal of The Electrochemical Society, 153 (8) G771-G777 (2006)] showed the effect of the sample clamping ring material on the formation of silicon grass in an ICP system (Alcatel A601E) used for Deep RIE. Their experiments showed that aluminum, commonly used as clamping ring material in etching tools, was not the best choice material; Instead, a ceramic clamping ring was proposed for the reduction of ring sputtering. Silicon grass as high as 200 µm and diameter of 600 nm was formed during the etching process, while the use of a ceramic ring resulted in drastic reduction of the silicon grass problem, due to less polarization of the insulating ceramic ring compared to the metallic ring.

Patick Garabedian et al. [Patick Garabedian, Philippe Pagnod-Rossiaux, Puech, MetZ-Tessy, US Patent 20020179246A1*]* designed an effective grounded shield to eliminate sputtering and excessive heating of the clamping ring during long etching processes, or chlorine-based plasma etching processes. This solution makes use of a shield mounted above the substrate holder using a mechanical flange, in order to protect it from ion erosion. The shield is grounded, and is mounted in a fixed distance above the clamping ring in order to avoid ring heating from ions. One disadvantage of this shield is the creation of plasma between the grounded shield and the substrate holder in the gap between them, due to the conductive nature of the ring. A second disadvantage is the absence of control of the sputtering caused by the clamping ring, which is sometimes desirable especially in polymeric surface treatment.

Similar work for has been demonstrated by Engelhardt Manfred et al. He designed a shield for protecting the chuck from erosion caused from ion bombardment. [Manfred Engelhardt, US Patent 20140134829A1*].*

Document KR 2004 0008882 discloses a static shield attached to an insulating window of a planar ICP plasma reactor. The static shield is made of silicon (Si) or silicon Carbide (SiC) and serves the purpose to reduce F radicals by etching the Si or SiC.

Document WO 00/23633 discloses an iris shaped shutter to confine or interrupt plasma distribution to the sample.

Finally, we note that most of the proposed shields are for ICP reactors and no shields are discussed for RIE reactors.

The present invention comes to fill in these gaps by proposing a new variable shield, appropriate for both RIE and ICP systems, which allows full control of sputtering, ranging from complete elimination of sputtering to maximum possible sputtering, and therefore allows full control of roughness formation during plasma etching or deposition. Therefore, according to the invention a variable Faraday shield according to claim 1 as well as the use of the variable Faraday shield according to claims 7 and 8 and a method for controlling roughness on processed substrate materials in a plasma reactor according to claim 9 are defined. Further embodiments of the invention are defined in the dependent claims.

### Summary of the invention

The present invention concerns a variable Faraday shield for a substrate holder, a clamping ring or an electrode or their combination in a low pressure (i.e. typically below 1Torr pressure) plasma reactor, e.g. in a RIE or ICP plasma reactor. The shield according to the present invention allows full control of sputtering, ranging from complete elimination of sputtering to maximum possible sputtering, and therefore allows full control of roughness formation. Variation is achieved by varying the amount of polarized surface of the substrate holder/electrode/ clamping ring or their combinations exposed to the plasma, the remaining surface being covered by a grounded shield comprising one metallic layer and optionally one bottom dielectric layer facing the substrate holder, the clamping ring or the electrode or their combination. By means of the proposed use of Teflon or other dielectric layer between the top metallic layer and the substrate holder/electrode/ clamping ring or their combinations the plasma is confined only in the processing area. According to the present invention a variable shielding with Teflon or other dielectric isolation from the substrate holder/electrode/ clamping ring or their combinations is proposed, in order to allow portion of ion flux / bombardment to reach the substrate holder/electrode/ clamping ring or their combinations and sputter the specific free areas revealed (i.e. not covered by the shield) in order to create controlled micro masking on the substrate being processed.

### Brief description of the drawings and images

Figure 1 shows typical low pressure plasma reactors (Figure 1a shows an ICP Reactor, and Figure 1b shows a RIE Reactor). In Figure 1a (1.1) is a Clamping Ring to secure the substrate. In Figure 1b (1.2) is a substrate holder or electrode.
Figures 2a to 2f show different embodiments of a variable Faraday shield for a substrate holder, a clamping ring or an electrode or their combination in a plasma reactor according to the present invention:

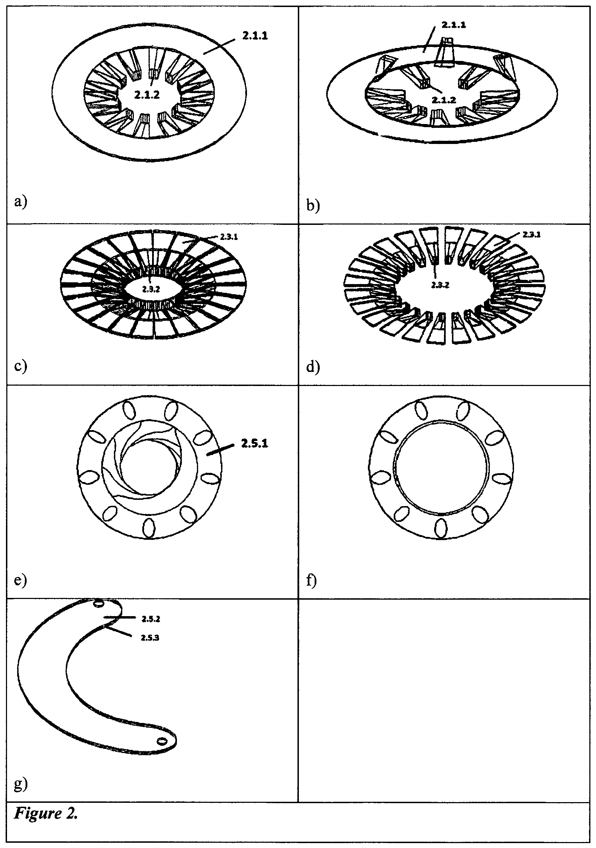

Figure 2a shows a first proposed embodiment of a variable Faraday shield with a ring-flap morphology with all the flaps closed.
Figure 2b shows the proposed embodiment of variable Faraday shield with a ring-flap morphology according to Figure 2a, when 3 flaps open up.
Figure 2c shows a second proposed embodiment of a variable Faraday shield having a pie like morphology fully closed.
Figure 2d shows the proposed embodiment of a variable Faraday shield according to Figure 2c, when it is 50% open.
Figure 2e shows a third proposed embodiment of a variable Faraday shield having a mechanical iris morphology, the iris being fully closed (except the processed substrate area).
Figure 2f shows the variable Faraday shield according to Figure 2e when the iris is open fully open.
Figure 2g shows one blade of the iris of the proposed variable Faraday shield according to Figure 2e, covered with a dielectric layer.

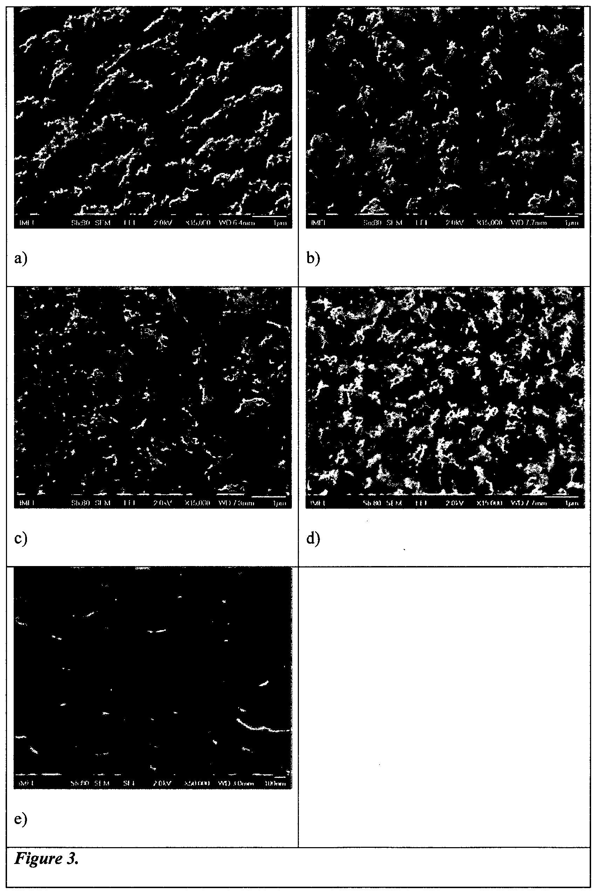

Figure 3a shows the evolution of roughness of a PMMA plate when there is no shield present.
Figure 3b shows the evolution of roughness of a PMMA plate when the shield is covering 50% the clamping ring.
Figure 3c shows the evolution of roughness of a PMMA plate when the shield is covering 63% the clamping ring.
Figure 3d shows the evolution of roughness of a PMMA plate when the shield is covering 75% the clamping ring.
Figure 3e shows the evolution of roughness of a PMMA plate when the shield is covering 100% the clamping ring.

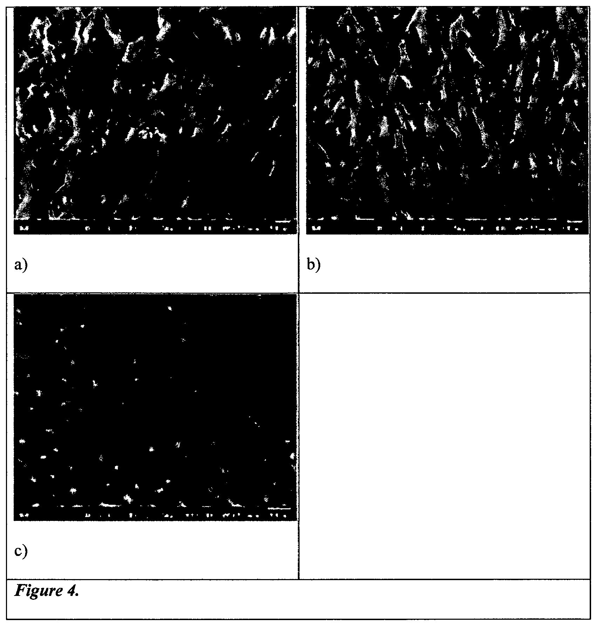

Figure 4a shows the evolution of roughness of a PMMA film coated on Silicon substarte when there is no shield present.
Figure 4b shows the evolution of roughness of a PMMA film coated on Silicon substrate when the shield is covering 63% the clamping ring.
Figure 4c shows the evolution of roughness of a PMMA film coated on Silicon substrate when the shield is covering 100% the clamping ring.

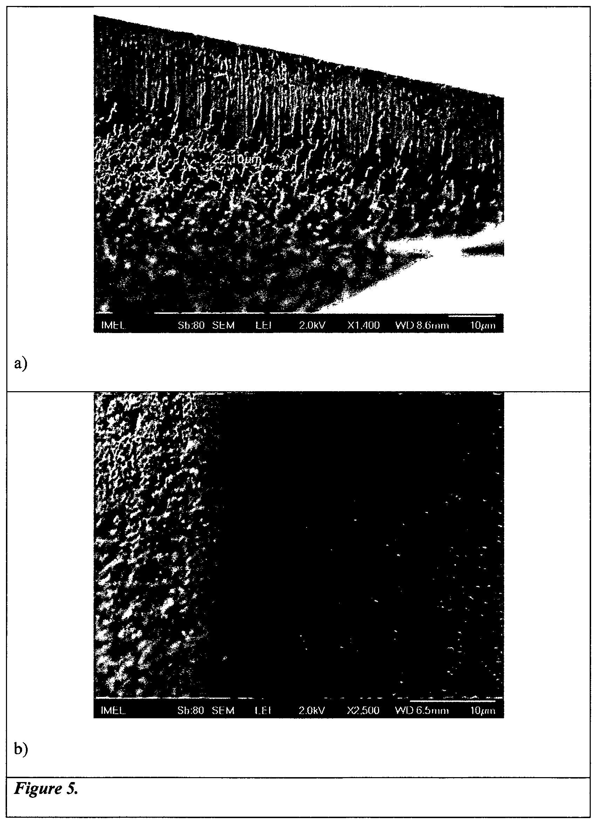

Figure 5a shows roughness evolution inside the microchannel of a PMMA plate when the shield is covering 100% the clamping ring.
Figure 5b shows roughness evolution inside the microchannel of a PMMA plate when the shield is not present.

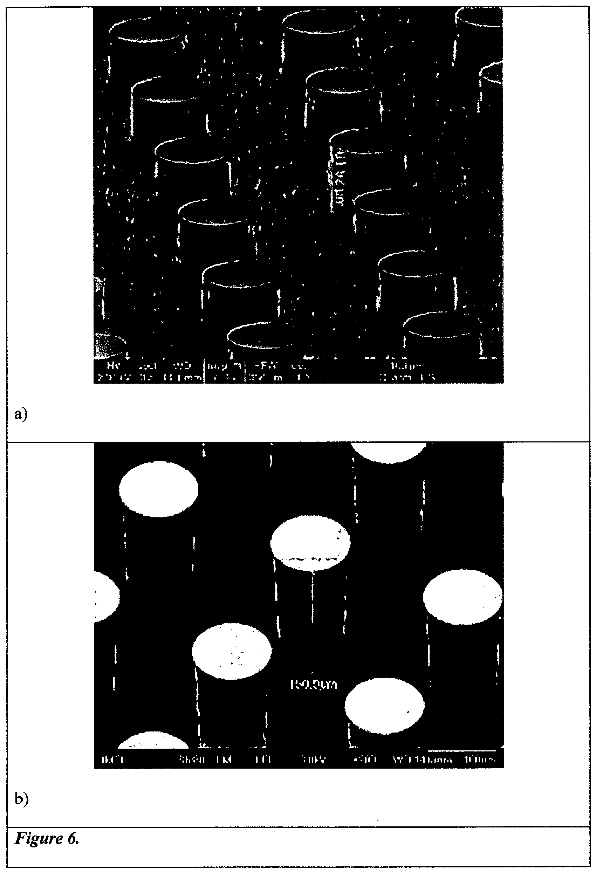

Figure 6a shows roughness evolution in-between the Silicon Pillars when the shield is not present.
Figure 6b shows roughness evolution in-between the Silicon Pillars when the shield is covering 100% the clamping ring.

### Detailed description of the invention

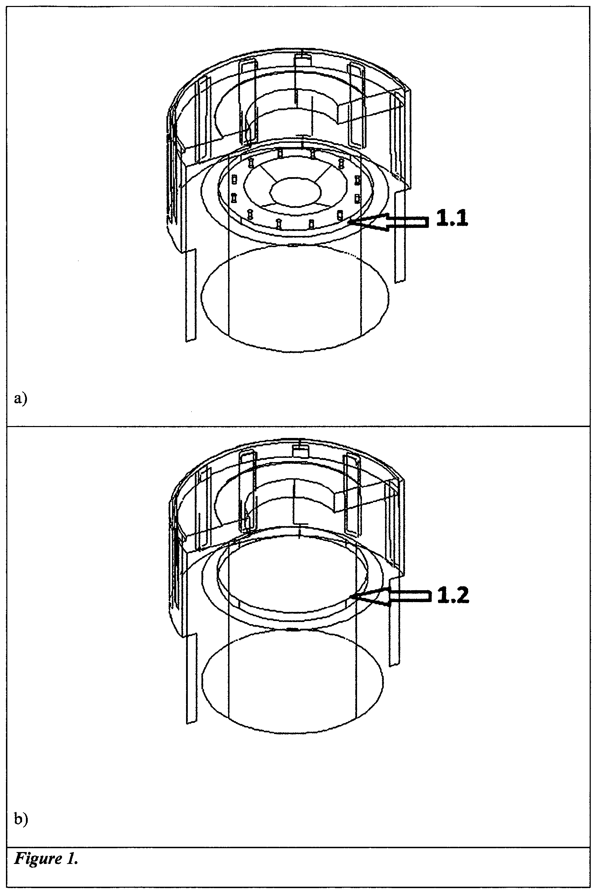

Figure 1 shows a drawing of a typical ICP Reactor (Figure 1a) and a typical RIE reactor (Figure 1b). The clamping ring to secure the substrate (1.1), and the substrate holder or electrode (1.2) are also shown. Such surfaces which support or host the substrate can be found in RIE or ICP or other low-pressure systems typically operating below 1Torr pressure.

By using the inventive variable Faraday shield the amount of surface surrounding the substrate which is exposed to the plasma and to ion bombardment and is therefore eroded by sputtering can be controllably varied. The surface to be variably exposed to the plasma can be a clamping ring, an electrode, or a substrate holder or their combination. The material of the clamping ring, or electrode or substrate holder or their combination can be metallic such as aluminum or stainless steel or other suitable material; it can also be dielectric such as quartz or alumina or other ceramic material; it can also be metallic with a top layer converted to dielectric such as anodized aluminum. By using the inventive variable Faraday shield controllable micro masking, and thus controllable roughness can be achieved on the processed substrate materials, due to controllable sputtering of the substrate material holder, that being a substrate holder, or on electrode or on an electrode covered by a dielectric, or a clamping ring. The materials to be processed can be organic polymers such as PMMA, PS, Polyimide PET, PVC, COP, COC and other or inorganic polymers such as PDMS or organosilicon and organometallic polymers or inorganic materials such as metals or semiconductors such as Si, Al, W or dielectrics such as Silicon dioxide, quartz, Pyrex, glass and others. There are many different possible embodiments of the inventive shield such that it can expose different amount of surface of the substrate holder, clamping ring or electrode or their combination to the plasma.

Schematic views of three possible proposed embodiments of a variable Faraday shield are given in Figures 2a, 2b, 2c, 2d, 2e, 2f, 2g.

A schematic view of the first proposed embodiment of a variable Faraday shield is shown in Figures 2a, 2b. This shield comprises two layers, one grounded top metallic layer denoted as 2.1.1 and one bottom dielectric layer denoted as 2.1.2 facing a substrate holder, a clamping ring or an electrode or their combination. These two layers are sliced like an outer ring with protruding flaps. The metallic layer is 1-3 mm thick while the dielectric layer is 1-20mm thick. In this embodiment, the variable shield exposes the electrode / substrate holder / ring surface to the plasma by lifting up the flaps of metal and dielectric. Figure 2a shows the shield closed, and Figure 2b shows the shield partially open.

A schematic view of the second proposed embodiment of a variable Faraday shield is shown in Figures 2c, 2d. This shield comprises two layers. One grounded top metallic layer denoted as 2.3.1 and one bottom dielectric layer denoted as 2.3.2 facing a substrate holder, a clamping ring or an electrode or their combination. These two layers are sliced in pieces like a pie. The metallic layer is 1-3 mm thick while the dielectric layer is 1-20mm thick. In this design, the variable shield exposes the electrode / substrate holder / ring surface to the plasma by sliding the pieces of metal and dielectric away from the center of the pie towards the plasma reactor wall. Figure 2c shows the shield closed, and Figure 2d shows the shield partially open.

A schematic view of the third proposed embodiment of a variable Faraday shield is shown in Figures 2e, 2f and 2g. This shield is a mechanical iris-like shield shown closed in Figure 2e and open in Figure 2f. It comprises one grounded top metallic layer denoted as 2.5.1, and a set of metallic blades shown in Figure 2g denoted as 2.5.2 optionally coated on their bottom surface with a dielectric layer denoted as 2.5.3, of 10-5000 micrometers thick facing a substrate holder, a clamping ring or an electrode or their combination. The grounded metallic layer is 1-3 mm thick while the metallic blades are a few 100s of micrometers up to a few mm thick. In this design, the variable faraday shield exposes the electrode / substrate holder / clamping ring surface to the plasma by opening the shutter like a mechanical iris.

In all three embodiments sputtering control of the electrode material, and thus roughness control, is achieved only through the exposed parts of the electrode/ substrate holder / clamping ring or their combination. The dielectric material is inserted for ensuring plasma confinement only in the processing area and not between the grounded variable shield and the electrode / substrate holder / clamping ring or their combination. Typical dielectric materials include but are not limited to Teflon, alumina, and ceramic layers in general, which are both electrical and thermal insulators.

### Examples

### Example 1: Controlled Roughness formation on a Poly methyl methacrylate polymer (here on referred as PMMA) plate during plasma treatment using a variable shield.

Experiments were conducted in an ICP MET Alcatel reactor using an anodized aluminum clamping ring and the variable shield according to the embodiment shown in Figures 2a and 2b. PMMA Plates were etched for the same time and under the same etching conditions: Etching was conducted in oxygen plasma, at 10mTorr pressure, 100sccm Oxygen gas flow, 1800W ICP source power, and 250W bias power, and etching time 5min. In Figures 3a, 3b, 3c, 3d, 3e below we present the difference in roughness in respect with the shielding coverage. We can clearly see the reduction of the roughness with reduction of the surface of the electrode exposed to ion bombardment.

In more detail when there is no shield, the maximum height of roughness is approximately 1.2 - 1.4 µm as shown in Figure 3a. When doing processing with 50% of shielding of the clamping ring, we notice a roughness height in the order of 0.8 - 1 µm as shown in Figure 3b. When doing processing with 63% of shielding of the clamping ring we obtain a roughness height of 0.6 - 0.7 µm as shown in Figure 3c. When doing processing with 75% shielding, the roughness height is further reduced to is 0.4 - 0.5 µm as shown in Figure 3d. Finally, in Figure 3e a 100% shielded ring is shown, and the roughness is minimized close to below 0.05µm as shown in Figure 3e.

### Example 2: Controlled Roughness formation on PMMA films during plasma treatment using a variable shield.

Experiments were conducted in an ICP MET Alcatel reactor using an anodized aluminum clamping ring and the variable shield according to the embodiment shown in Figures 2a and 2b. PMMA films were etched for the same time and the same etching conditions as described in example 1, except for the etching time, which is set to 1min. In Figures 4a, 4b, 4c we present the difference in roughness with respect with the shielding coverage of the clamping ring. We can clearly see the reduction of the roughness with reduction of the surface of the electrode exposed to ion bombardment. In more detail for 1 min of O2 plasma etch when there is no shield present on the clamping ring the maximum height in roughness is 200-250 nm as seen in Figure 4a. With 63% of shielding of the ring we notice a height of roughness in the order of 150 - 200 nm, shown in Figure 4b. Finally, a 100% shielded clamping ring results in roughness below 20 nm, as shown in Figure 4c.

### Example 3: Diminishing Roughness in plasma etched polymeric PMMA micro channels

The variable shield proposed according to the embodiment shown in Figures 2a and 2b was used to etch micro channels on PMMA plates. First, a lithographic step was conducted on a PMMA plate in order to define the area where the microchannel would be etched. Subsequently, etching experiments were conducted in an ICP MET Alcatel reactor using an anodized aluminum clamping ring. Two experiments were conducted: one without and one with the variable shield fully closed. Etching conditions similar to example 1 were used and etching time was 10min. Figure 5a (an SEM photograph) shows a very rough microchannel when the clamping ring of the sample is exposed to ion bombardment (no shield case), while Figure 5b (SEM) shows practically elimination of roughness inside the microchannel when the shield is present and fully closed. Roughness was reduced from 10 µm to below 0.05 µm in the two cases respectively.

### Example 4: Elimination of roughness in Silicon plasma etching using the alternating gas chopping Process

The variable shield according to the embodiment shown in Figures 2a and 2b was used to etch Silicon micro pillars. First, a lithographic step was conducted on a Silicon wafer, in order to create the diameter and pitch of the mask for the Silicon plasma etching. Subsequently etching experiments were conducted in an ICP MET Alcatel reactor using an anodized aluminum clamping ring. Conditions were as follows: Etching was conducted in alternating SF₆/C₄F₈ plasma, at 37mTorr pressure, 175/110sccm gas flow, duration of gas cycle 7s/3s, 1800W ICP source power, and 50W bias power, and etching time 21 and 50min. Two experiments were conducted: one without and one with the variable shield. When the variable Faraday shield covering the clamping ring was fully closed silicon etching for the creation of the nano pillars for 50 minutes occurred. The resulting SEM Figure 6b shows practically elimination of roughness in between the pillars in comparison with the one without the ring according Figure 6a where significant roughness is shown even for less etching time 20min.
elimination of roughness in between the pillars in comparison with the one without the ring according image 4a where significant roughness is shown even for less etching time 20min.

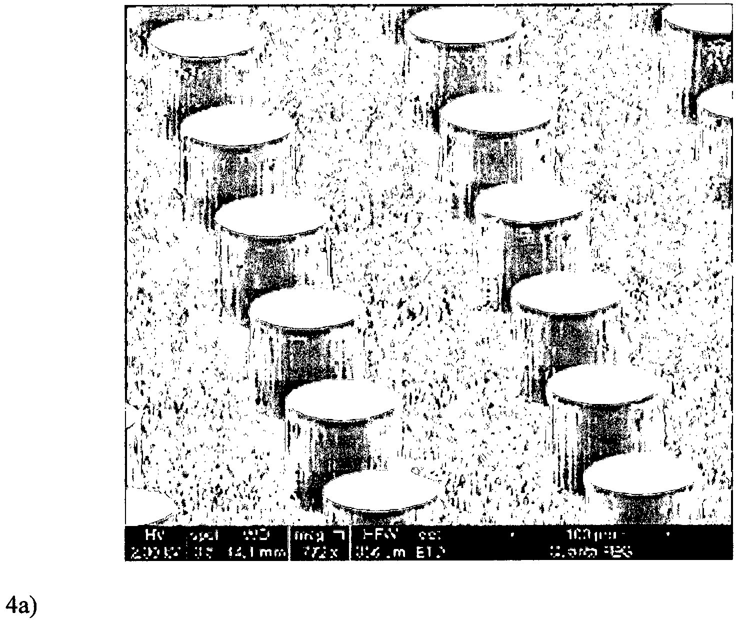

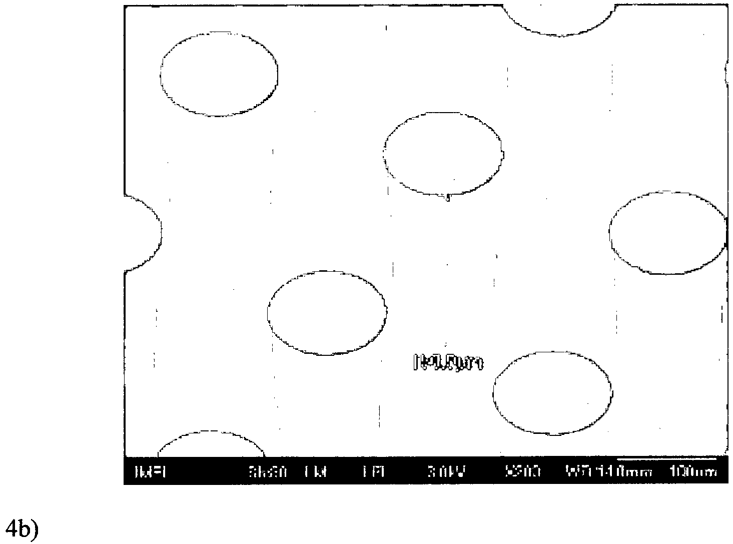

## Claims

1. A variable Faraday shield, configured to control the exposure of substrate material holder being a clamping ring or substrate holder or electrode or combination of them in a plasma reactor to the plasma by variation of shielding and thus to control roughness on the processed substrate materials, due to controllable sputtering of the substrate material holder, ranging from complete elimination of sputtering to maximum possible sputtering, and to allow full control of roughness formation,
wherein the shield is located inside the reactor and comprises a grounded metallic layer and one dielectric layer on the metallic layer, the dielectric layer facing the substrate material holder, wherein the shield comprises moving parts configured to achieve variation of the shielding by varying the exposure of the surface of the substrate holder, clamping ring or electrode or their combination to the plasma.

2. A variable Faraday shield according to claim 1, **characterized in that** the moving parts of the shield are flaps which can be lifted.

3. A variable Faraday shield according to claim 1, **characterized in that** the moving parts of the shield are pie-like slices which can be slided in and out radially.

4. A variable Faraday shield according to claim 1, **characterized in that** the moving parts of the shield are a mechanical iris-like construction which can be rotated to open or close.

5. A variable Faraday shield according to claim 1, **characterized in that** the dielectric layer is a Teflon, alumina or ceramic layer.

6. A variable Faraday shield according to claim 1 to 5, **characterized in that** the thickness of the grounded metallic layer is in the range of 1-3 millimeters and **in that** the thickness of the dielectric layer is in the range of 10-20000 micrometers.

7. Use of a variable Faraday shield according to one of the preceding claims for controlled reduction of ion-bombardment-induced sputtering from such substrate holder or clamping ring or electrode or their combination when the plasma is on.

8. Use of a variable Faraday shield according to one of the preceding claims 1-6 for controlling the roughness created on plasma processed substrates.

9. Method for controlling roughness on processed substrate materials in a plasma reactor, the substrate material being held by a substrate material holder, the substrate material holder being a clamping ring or substrate holder or electrode or combination of them, wherein a variable Faraday shield according to claims 1-6, configured to control the exposure of the substrate material holder to the plasma by variation of shielding and thus to control roughness on the processed substrate materials due to controllable sputtering of the substrate material holder is used, the sputtering ranging from complete elimination of sputtering to maximum possible sputtering, wherein the shield is located inside the reactor and comprises a grounded metallic layer and one dielectric layer on the metallic layer, the dielectric layer facing the substrate material holder, wherein the variation of shielding is achieved by varying the surface of the substrate material holder exposed to the plasma by using moving parts of the shield.

## Patentansprüche

1. Ein verstellbarer faradayscher Schirm, konfiguriert zur Kontrolle der Plasmaexposition des Substratmaterialhalters im Plasmareaktor, entweder ein Spannring, ein Substratträger, eine Elektrode oder eine Kombination dieser Komponenten, durch Änderung der Abschirmung und somit zur Kontrolle der Rauigkeit auf den bearbeiteten Substratmaterialien aufgrund des regulierbaren Sputterns des Substratmaterialhalters, in einem Bereich von der kompletten Unterdrückung des Sputterns bis zum maximal möglichen Sputtern, was die vollständige Kontrolle der Entwicklung der Rauigkeitsstruktur ermöglicht, welcher sich dadurch auszeichnet, dass sie sich innerhalb des Reaktors befindet und aus einer geerdeten Metallschicht und einer dielektrischen Schicht auf der Metallschicht besteht, welche dem Substratmaterialhalter zugewandt ist, wobei die Verstellbarkeit der Abschirmung durch das Verändern der Oberfläche des Substratmaterialhalters, die zum Plasma exponiert ist, durch den Einsatz beweglicher Teile des Schirms erzielt wird.

2. Ein verstellbarer faradayscher Schirm entsprechend Anspruch 1, der sich dadurch auszeichnet, dass die beweglichen Teile des Schirms Klappen sind, die angehoben werden können.

3. Ein verstellbarer faradayscher Schirm entsprechend Anspruch 1, der sich dadurch auszeichnet, dass die beweglichen Teile des Schirms tortenförmige Kreisausschnitte sind, die radial nach innen ind aussen verschoben werden können.

4. Ein verstellbarer faradayscher Schirm entsprechend Anspruch 1, der sich dadurch auszeichnet, dass die beweglichen Teile des Schirms in einer mechanischen Konstruktion ähnlich einer Irisblende durch drehen geöffnet und geschlossen werden können.

5. Ein verstellbarer faradayscher Schirm entsprechend Anspruch 1, der sich dadurch auszeichnet, dass die dielektrische Schicht eine Teflon-, Aluminium- oder Keramikschicht ist.

6. Ein verstellbarer faradayscher Schirm entsprechend Anspruch 1 bis 5, der sich dadurch auszeichnet, dass die Dicke der geerdeten Metallschicht im Bereich von 1 - 3 Millimetern liegt und dass die Dicke der dielektrischen Schicht im Bereich von 10-20000 Mikrometern liegt.

7. Die Nutzung eines verstellbaren faradayschen Schirms entsprechend der vorhergehenden Ansprüche zur kontrollierten Reduzierung des Sputterns induziert durch Ionenbeschuss von einem Substratträger, einem Spannring, einer Elektrode oder deren Kombination, wenn sich das Plasma gebildet hat.

8. Die Nutzung eines verstellbaren faradayschen Schirms entsprechend der Ansprüche 1 bis 6 zur Kontrolle der Rauigkeit, die auf dem Plasma bearbeiteten Substrat erzeugt wird.

9. Eine Methode zur Kontrolle der Rauigkeit auf bearbeiteten Substratmaterialien in einem Plasmareaktor, wobei das Substratmaterial von einem Substratmaterialhalter gehalten wird und der Substratmaterialhalter ein Spannring, ein Substratträger, eine Elektrode oder eine Kombination dieser Komponenten ist, indem ein verstellbarer faradayscher Schirm, entsprechend der Ansprüche 1 bis 6, konfiguriert zur Kontrolle der Plasmaexpostion des Substratmaterialhalters durch die Verstellbarkeit der Abschirmung und somit zur Kontrolle der Rauigkeit auf den bearbeiteten Substratmaterialien aufgrund des regulierbaren Sputterns des Substratmaterialhalters, benutzt wird, bei einem Sputtern in einem Bereich von der kompletten Unterdrückung bis zum maximal möglichen Sputtern, wobei der Schirm sich innerhalb des Reaktors befindet und aus einer geerdeten Metallschicht und einer dielektrischen Schicht aud der Metallschicht besteht, welche dem Substratmaterialhalter zugewandt ist, und die Änderung der Abschirmung durch das Verändern der plasmaexponierten Oberfläche des Substratmaterialhalters durch bewegliche Teile des Schirms erzielt wird.

## Revendications

1. Un blindage de Faraday variable, configuré pour contrôler l'exposition d'un support de matériau de substrat, ledit support étant une bague de serrage ou un support de substrat ou une électrode ou une combinaison de ceux-ci dans un réacteur à plasma, au plasma par variation du blindage et ainsi contrôler la rugosité sur les matériaux de substrat traités, en raison de la pulvérisation contrôlable du support de matériau de substrat, allant de l'élimination complète de pulvérisation à la pulvérisation maximale possible, et pour permettre un contrôle total de la formation de rugosité, **caractérisé en ce que** le blindage est situé à l'intérieur du réacteur et comprend une couche métallique mise à la terre et un diélectrique sur la couche métallique, la couche diélectrique faisant face au support de matériau de substrat, moyennant quoi la variation du blindage est obtenue en faisant varier la surface du support de matériau de substrat exposée au plasma en utilisant des pièces mobiles du blindage.

2. Un blindage de Faraday variable selon la revendication 1, **caractérisé en ce que** les parties mobiles du blindage sont des volets relevables.

3. Un blindage de Faraday variable selon la revendication 1, **caractérisé en ce que** les parties mobiles du blindage sont des tranches de forme triangulaire qui peuvent être positionnées vers l'intérieur et vers l'extérieur radialement.

4. Un blindage de Faraday variable selon la revendication 1, **caractérisé en ce que** les parties mobiles du blindage sont une construction mécanique en forme d'iris qui peut être tournée pour s'ouvrir ou se fermer.

5. Un blindage de Faraday variable selon la revendication 1, **caractérisé en ce que** la couche diélectrique est une couche de Téflon, d'alumine ou de céramique.

6. Un blindage de Faraday variable selon les revendications 1 à 5, **caractérisé en ce que** l'épaisseur de la couche métallique mise à la terre est de l'ordre de 1 à 3 millimètres et **en ce que** l'épaisseur de la couche diélectrique est de l'ordre de 10 à 20000 micromètres.

7. Utilisation d'un blindage de Faraday variable selon l'une des revendications précédentes pour la réduction contrôlée de la pulvérisation induite par bombardement ionique du tel support de substrat ou de la telle bague de serrage ou de la telle électrode ou de leur combinaison lorsque le plasma est activé.

8. Utilisation d'un blindage de Faraday variable selon l'une des revendications précédentes 1 à 6 pour contrôler la rugosité créée sur des substrats traités au plasma.

9. Procédé de contrôle de la rugosité sur des matériaux de substrat traités dans un réacteur à plasma, le matériau de substrat étant maintenu par un support de matériau de substrat, le support de matériau de substrat étant une bague de serrage ou un support de substrat ou une électrode ou une combinaison de ceux-ci, dans lequel un blindage de Faraday variable selon les revendications 1 à 6, configuré pour contrôler l'exposition du support de matériau de substrat au plasma par variation du blindage et ainsi contrôler la rugosité sur les matériaux de substrat traités en raison de la pulvérisation contrôlable du support de matériau de substrat est utilisé, la pulvérisation allant de l'élimination complète de pulvérisation à la pulvérisation maximale possible, le blindage étant situé à l'intérieur du réacteur et comprend une couche métallique mise à la terre et une couche diélectrique sur la couche métallique, la couche diélectrique faisant face au support de matériau de substrat, la variation du blindage étant obtenue en faisant varier la surface du support de matériau de substrat exposée au plasma en utilisant des pièces mobiles du blindage.
